# EUROPEAN PATENT APPLICATION

(11) **EP 1 806 777 A1**
(43) Date of publication of application: **11.07.2007**
(21) Application number: 05780854.5
(22) Date of filing: 29.08.2005
(51) Int. Cl.: H01L 21/324

(54) **VERTICAL BOAT FOR HEAT TREATMENT AND HEAT TREATMENT METHOD**

(30) Priority: 27.10.2004 JP 2004312893
(71) Applicant: Shin-Etsu Handotai Co., Ltd, Tokyo 100-0005 (JP)
(72) Inventor: AIHARA, Ken, Isobe R & D Center, Annaka-shi, Gunma 379-0196 (JP); TAKAHASHI, Shuji, Kamisato Plant, Gunma-gun, Gunma 370-3533 (JP); UEHARA, Yoshiyuki, Kamisato Plant, Gunma-gun, Gunma 370-3533 (JP)
(74) Representative: Wibbelmann, Jobst
(86) International application number: PCT/JP2005/015618
(87) International publication number: WO 2006/046348

(57) **Abstract**

The present invention is a vertical boat 8 for heat treatment by which a plurality of wafer-like objects to be treated are supported with an interval in a vertical direction by a column having support surfaces and carried into a vertical heat treatment apparatus and carried out, wherein a lower surface of each of the wafer-like objects to be treated is supported by a plurality of support surfaces 4 formed on the column, a flatness of a plane formed by the plurality of the support surfaces being in contact with a same one of the objects to be treated is 0.03 mm or less, and a parallelism thereof is 0.07 mm or less. Thereby, there can be provided a vertical boat for heat treatment and a method for heat treatment by which even if the heat treatment is performed at an extremely high temperature of 1200°C or more, a slip dislocation can be very effectively prevented from being generated in a wafer or the like during the heat treatment and further productivity is high and the wafer can be made to have a surface layer of high quality.

## Description

### Technical Field

The present invention relates to a vertical boat for heat treatment of a semiconductor wafer or the like, in particular, to a vertical boat for heat treatment and a method for heat treatment which are suitable when silicon wafers are heat-treated.

### Background Art

In the case in which a device is fabricated by using a wafer sliced from a semiconductor ingot such as a silicon single crystal, there are multiple steps from a manufacturing process of the wafer to a formation process of the device. One of these steps is a heat treatment step. This heat treatment step is a very important process that is performed for the purposes of formation of a defect-free layer, gettering, crystallization, formation of an oxide film, diffusion of impurities, and so forth, in a surface layer of a wafer.

For example, a silicon single crystal produced by a Czochralski method is generally grown so that the crystal growth rate is relatively high from the aspect of productivity. In this case, agglomerate (void) of vacancy-type point defects is formed in the silicon single crystal. Moreover, if the void is exposed on the wafer surface sliced from this silicon single crystal, it is called as COP (Crystal Originated Particle) and can be easily detected by a particle counter or the like. And, it is known that crystal defects such as the COPs or the voids in the vicinity of the wafer surface degrade breakdown voltage characteristics of the semiconductor device. Therefore, recently, demand of an annealed wafer, which is capable of annihilation of the COPs and the voids in the wafer surface and in the vicinity of the surface by subjecting a silicon wafer to a high-temperature heat treatment under an inert atmosphere, has been rapidly increased.

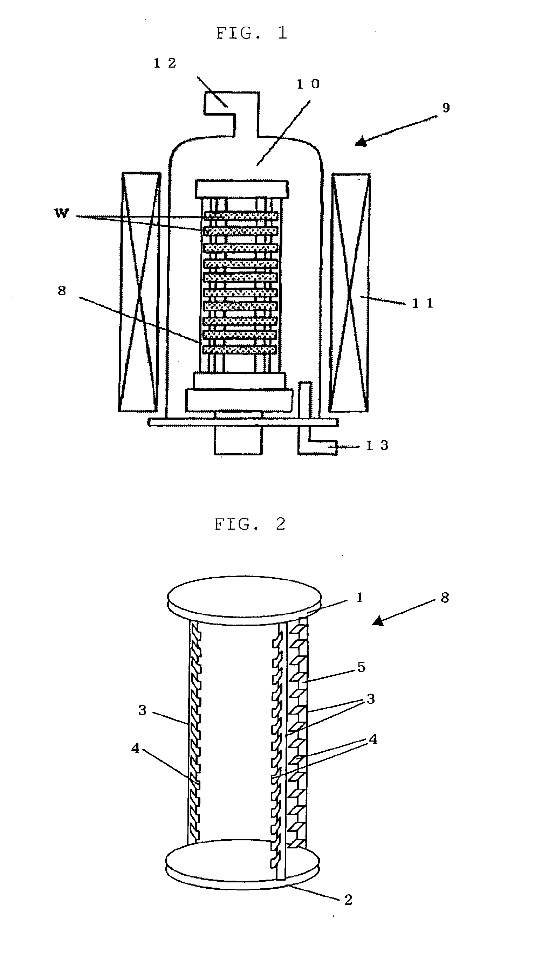

As a heat treatment apparatus used in a heat treatment step for such an annealed wafer, as a diameter of a wafer is larger as shown in Fig. 1, a vertical heat treatment furnace 9 for heat-treating a large number of wafers W in a state of being horizontally supported with determined intervals has been mainly used. The wafers W in the heat treatment furnace 9 can be heated with a heater 11 provided around a reaction chamber 10. During the heat treatment, a gas is introduced into the reaction chamber 10 through a gas inlet duct 12, flows from above to below, and discharged to the outside from an gas outlet duct 13. In addition, the used gas is different according to the object of the heat treatment. However, mainly, H₂, N₂, O₂, Ar, or the like is used. In the case of impurity diffusion, such a gas is also used as a carrier gas for an impurity compound gas.

When the wafers W are heat-treated by using such a vertical heat treatment furnace 9, a vertical boat 8 for heat treatment (Hereinafter, occasionally referred to as "a boat for heat treatment", "a vertical boat", or simply "a boat") for horizontally setting a large number of the wafers W therein is used.

As such a boat for heat treatment, there is a boat called as a ladder boat, which has a structure in which three or more columns made of, for example, quartz are provided, for example, between a circular top plate and a bottom plate that are disposed with facing to each other in the vertical direction and a peripheral portion of each of the wafers is inserted and held in groove parts formed in the columns.

Moreover, as another type of the boat for heat treatment, there is a boat called as a ring boat, in which support members with a ring shape having a flat support surface are placed on a column so that wafers can be put on the support members.

One target of the ring boat is that when a rising or falling temperature rate in the heat treatment furnace is high, the rising or falling temperature rates in the central portion of the wafer and those in the peripheral portion thereof are aligned, by contacting the peripheral portion of the wafer with the support member and enlarging heat capacity and slowing the rising or falling temperature rate in the peripheral portion.

However, because in this ring boat, wafers are transported by a loader, it has been necessary that an alignment pitch is set to be larger than that of the ladder boat. As a result, there is a disadvantage of lower productivity than that of the ladder boat. For solving such a problem, a boat for heat treatment in which arc-shaped support parts are integrally formed in one cylinder to be a boat main body (column) has been proposed (see, Japanese Patent Application (Kokai) No. 5-129214).

Furthermore, the ladder boat or the ring boat made of silicon carbide (SiC) having a higher melting point than that of quartz has been produced, and these boats for heat treatment are suitable for heat treatment at a high temperature.

However, in the above-described ladder boat, there has been caused a problem that a large moment corresponding to its own weight works on support points in the outer peripheral portion of the wafer and the stress in the vicinity of the support point becomes excessively large, and thereby a crystal defect called as slip dislocation is easily generated in the vicinity of points of the wafer that are supported by the column of the boat for heat treatment in the case of heat-treating the wafers at a high temperature of, for example, 1050°C or more.

As measures against this, for example, in Japanese Patent Application (Kokai) No. 10-22227, there has been disclosed that in a boat for heat treatment by which a plurality of objects to be treated are respectively supported almost horizontally with an interval in the vertical direction to each other between a plurality of columns and carried into a vertical heat treatment furnace and carried out, by forming, in the column, a plurality of arm portions each extending toward an inward side of the objects to be treated with an interval in the vertical direction and supporting, on an upper surface of an inner end side of each of the arm portions, an inward side of a peripheral border portion of each of the objects to be treated, the moment can be smaller than that of the case of supporting it on the outer peripheral border portion, and thereby generation of slip dislocations can be suppressed.

However, for annihilating a COP and a void in the wafer surface and in the vicinity of the surface, it is necessary that the heat treatment is performed at an extremely high temperature of approximately 1200°C, and therefore, the effect of preventing slip dislocation by the above-described improvement is not so high.

On the other hand, even in a boat for heat treatment in which long grooves for supporting the wafer peripheral portion are formed in the inner face of a cylinder part so that a large part of the peripheral portion of the wafer can be supported and the own weight of the wafer can be distributed, the wafer peripheral portion is in a state of being supported not on a plane but on many points because a flatness of the support surface of each of the grooves with which the wafer is directly in contact is not sufficiently controlled and therefore a large waviness is generated in the support surface of each of the grooves when the support surfaces are viewed microscopically.

As measures against this, for example, in Japanese Patent Application (Kokai) No. 9-50967, it has been disclosed to constitute to set a flatness of the support surface of the wafer peripheral portion to be 0.1 mm or less.

However, even in this method, when the heat treatment is performed at an extremely high temperature of 1200°C or more, a slip dislocation has been occasionally generated. Moreover, in the structure of holding most of the wafer peripheral portion in an arc shape, there is a fear of harmful effect on wafer quality caused by stagnancy in a flow of a gas to the wafers and prevention of heat radiation to the wafers due to increase of the volume of the entirety of the support body. Furthermore, the structure has a disadvantage of being easily damaged in the production process of the boat because the shape of the support body is complex.

### Disclosure of the Invention

The present invention has been made to solve the above problems. An object of the present invention is to provide a vertical boat for heat treatment and a method for heat treatment by which even if the heat treatment is performed at an extremely high temperature of 1200°C or more, a slip dislocation can be very effectively prevented from being generated in a wafer or the like during the heat treatment and further productivity is high and the wafer can be made to have a surface layer of high quality.

To achieve the above object, the present invention provides a vertical boat for heat treatment by which a plurality of wafer-like objects to be treated are supported with an interval in a vertical direction by a column having support surfaces and carried into a vertical heat treatment apparatus and carried out, wherein a lower surface of each of the wafer-like objects to be treated is supported by a plurality of support surfaces formed on the column, a flatness of a plane formed by the plurality of the support surfaces being in contact with a same one of the objects to be treated is 0.03 mm or less, and a parallelism thereof is 0.07 mm or less.

In a vertical boat for heat treatment by which a plurality of wafer-like objects to be treated are supported and carried into a vertical heat treatment apparatus and carried out, when a lower surface of each of the wafer-like objects to be treated is supported by a plurality of support surfaces formed on the column and a flatness of a plane formed by the plurality of the support surfaces being in contact with a same one of the objects to be treated is 0.03 mm or less and a parallelism thereof is 0.07 mm or less as described above, the support surfaces and each of the wafer-like object to be treated certainly become not in point contact but in plane contact even when the support surfaces are viewed microscopically, and the own weight of the wafer-like object to be treated can be very effectively distributed. Therefore, even in the temperature rising when particularly a slip dislocation is easily generated, the stress can be distributed and the productivity is extremely high and the slip dislocation can be very effectively prevented from being generated. Moreover, the support area can be small because the wafer is supported on a plurality of support surfaces, and stagnancy is not caused in the flow of the gas to the objects to be treated and heat radiation to the objects to be treated is not prevented, and therefore, the harmful effects on the quality of the wafer-like objects to be treated such as degradation of uniformity of oxide film thickness can be prevented. In this case, it is the most preferable that the flatness and the parallelism are respectively 0 mm. However, the current measurement precision is limited to 0.001 mm.

In the above case, it is preferable that in the column, a plurality of arm portions each extending toward an inward side are formed with an interval in the vertical direction, and on an upper surface of an inner end side of each of the arm portions, an inward side of a peripheral border portion of each of the wafer-like objects to be treated is supported.

When an inward side of a peripheral border portion of each of the wafer-like objects to be treated is supported as described above, the moment becomes smaller than that of the case of supporting the wafer on the outer peripheral border portion, and as a result, the stress due to the load on the support points becomes smaller and the slip dislocation can be more effectively prevented from being generated.

Moreover, it is preferable that the vertical boat for heat treatment has, at least, two columns.

By supporting the wafer-like objects to be treated by a plurality of columns, the structure of the vertical boat for heat treatment can be stabilized, and the auxiliary members required for the support are reduced, and production cost is reduced and productivity can be enhanced. Moreover, flow of the gas can be easily uniformed, and also heat radiation to the wafers becomes good. In this case, it is the most preferable that the number of the columns is two to four. If the number of the columns is five or more, stagnancy becomes easily caused in the flow of the gas to the wafers.

Moreover, it is preferable that the column is provided between a top plate and a bottom plate.

When the column is provided between a top plate and a bottom plate, the structure of the vertical boat for heat treatment can be stabilized, and the flow of the gas or the heat radiation to the objects to be treated in a high-temperature heat treatment can become appropriate, and the quality of the objects to be treated can be improved and the productivity can be enhanced.

Furthermore, it is preferable that a sum total of contact areas of the wafer-like object to be treated and the plurality of support surfaces formed on the column is 2% or less of an area of the wafer-like object to be treated.

When a sum total of contact areas of the wafer-like object to be treated and the plurality of support surfaces formed on the column is 2% or less of an area of the wafer-like object to be treated, the flow of the gas or the heat radiation to the objects to be treated can become appropriate, and the harmful effects on the quality of the wafer-like objects to be treated such as degradation of uniformity of oxide film thickness and so forth can be prevented more certainly. In this case, if the sum total of contact areas of the wafer-like object to be treated and the plurality of support surfaces formed on the column is less than 1% of the area of the wafer-like object to be treated, the stress due to the load in the support points increases. Therefore, it is preferable that the sum total of contact areas of the wafer-like object to be treated and the plurality of support surfaces formed on the column is 1% or more of the area of the wafer-like object to be treated.

It is preferable that at least, the column of the vertical boat for heat treatment is made of any one of quartz glass, silicon carbide, silicon, and complex of silicon carbide and silicon.

When at least the column are made of any one of these materials, the boat has excellent heat resistance and therefore does not become deformed even in a high-temperature heat treatment. Moreover, the contamination to the wafer-like objects to be treated can be suppressed as much as possible. In particular, in the case in which the heat treatment temperature is in the range of approximately 1200°C to 1300°C, it is preferable that silicon carbide, which is particularly excellent in heat resistance, is used.

Furthermore, the present invention provides a method for heat-treating a semiconductor wafer, wherein by using the above-described vertical boat for heat treatment, the semiconductor wafer supported by the boat is heat-treated at a temperature of 1000°C or more, and a melting point of the semiconductor wafer or less.

A silicon wafer and so forth are occasionally heat-treated at a high temperature of, particularly, 1000°C or more and its melting point or less. Moreover, in such a high temperature range, a slip dislocation is easily generated. Accordingly, by performing heat treatment by using the vertical boat for heat treatment of the present invention, a slip dislocation is not caused, and productivity and yield can be improved.

It is preferable that as the semiconductor wafer, a silicon wafer having a diameter of 300 mm or more is heat-treated.

In a silicon wafer having a diameter of 300 mm or more, temperature in the plane easily becomes non-uniform because of a large area, and its own weight is heavy and the load concentrates on the support points, and particular, a slip dislocation is easily generated. However, by using the vertical boat for heat treatment according to the present invention, a large number of wafers can be heat-treated with effectively suppressing generation of slip dislocations. Therefore, the present invention is particularly effective for heat treatment of a silicon wafer having a diameter of 300 mm or more.

According to the vertical boat for heat treatment of the present invention, even if the heat treatment is performed at an extremely high temperature of 1200°C or more, a slip dislocation can be very effectively prevented from being generated in a wafer or the like during the heat treatment and further productivity is high and the wafer can be made to have a surface layer of high quality.

### Brief Explanation of the Drawings

Fig. 1 is a schematic view showing an example of a vertical heat treatment furnace.
Fig. 2 is a perspective view showing an example of a vertical boat for heat treatment according to the present invention.
Fig. 3 is a section view of the vertical boat for heat treatment of Fig. 2.
Fig. 4 are a conceptual view (a) for explaining the case in which both of the flatness and the parallelism are large, a conceptual view (b) for explaining the case in which both of the flatness and the parallelism are small, and a conceptual view (c) for explaining the case in which the flatness is small and the parallelism is large.
Fig. 5 is a diagram showing individual flatnesses of the respective support surfaces of the vertical boat for heat treatment used in Example 1.
Fig. 6 is a diagram showing individual parallelisms of the respective support surfaces of the vertical boat for heat treatment used in Example 1.
Fig. 7 is a diagram showing flatnesses and parallelisms of the respective slots of the vertical boat for heat treatment used in Example 1.
Fig. 8 is a diagram showing lengths of slip dislocations in Example 1.

### Best Mode for Carrying out the Invention

With respect to a flatness of a support surface of a vertical boat for heat treatment being in contact with a wafer-like object to be treated, the boat for holding wafers in an arc shape has been investigated. However, it has been impossible to certainly prevent a slip dislocation from being generated. The present inventors have investigated thoroughly, and consequently found that in the case of supporting a wafer on a plurality of support surfaces, not only a flatness of the support surfaces of the vertical boat for heat treatment but also both of the flatness and the parallelism are controlled, and thereby, generation of slip dislocations can be prevented very effectively, and the present inventors have accomplished the present invention.

Hereinafter, as a preferable embodiment, the vertical boat for heat treatment according to the present invention, which is used when wafer-like objects to be treated are heat-treated, will be specifically explained with reference to appended drawings.

Fig. 2 shows a schematic of an example of a vertical boat for heat treatment according to the present invention. In this vertical boat 8 for heat treatment, at least, three columns 3 having support surfaces 4 are placed, and fixed between a top plate 1 and a bottom plate 2. Shape, size, and disposition, of each of the columns are appropriately set by considering space that a wafer-transporting jig passes through or width that the atmospheric gas passes through.

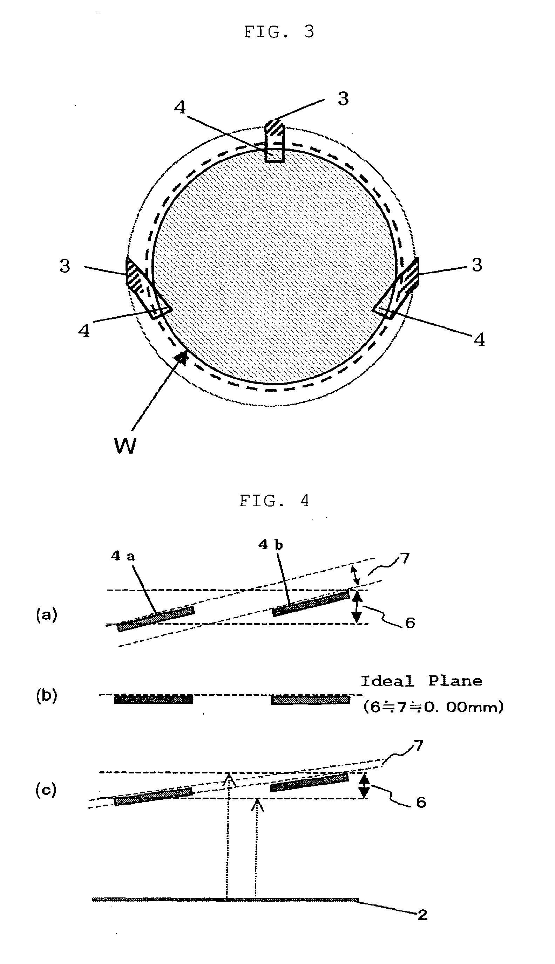

As shown in Fig. 3, three support surfaces 4 for supporting a same object W to be treated by three support columns 3 are formed in an inward side.

At this time, in the present invention, a flatness of a plane formed by the plurality of the (three) support surfaces 4 being in contact with the same object W to be treated is 0.03 mm or less, and a parallelism thereof is 0.07 mm or less.

Here, a parallelism is a difference between the maximum and the minimum of coordinates in the vertical direction in the relation between a plane to be measured and a reference plane that is a flat plane. A flatness is a difference between the maximum and the minimum in the vertical direction to an average plane that is a flat plane calculated in a plane to be measured by a least-square method. A flatness and a parallelism of a plane formed by a plurality of support surfaces 4 (in Fig. 4, for convenience, two planes 4a and 4b are used for the explanation) being in contact with the same object W to be treated in the present invention will be explained.

As shown in Fig. 4, a parallelism of a plane formed by a plurality of support surfaces 4a, 4b means the difference 6 between the maximum and the minimum of distances in the vertical direction in the relation between the reference plane that is an approximately flat plane (for example, a bottom surface of the bottom plate 2 of the vertical boat for heat treatment) and a plurality of the support surfaces. And, a flatness of a plane formed by a plurality of support surfaces 4a, 4b means the difference 7 between the maximum and the minimum in the vertical direction to each of the average planes calculated by a least-square method in the relation among only the plurality of the support surfaces. Measurement of the flatness and the parallelism is performed by using a 3D measurement equipment (for example, manufactured by MITUTOYO CORPORATION, or so forth) and first measuring the bottom surface of the boat and calculating the reference plane and then measuring the respective support surfaces in the same manner and calculating the flatness and the parallelism.

And, when the flatness of a plane formed by the plurality of the support surfaces 4a, 4b being in contact with the same object W to be treated is 0.03 mm or less and the parallelism thereof is 0.07 mm or less, the support surfaces and the object W to be treated are certainly in plane contact, and a slip dislocation can be very effectively prevented from being generated.

That is, for example, as shown in Fig. 4(c), when the boat has a plurality of support surfaces, even if the flatness 7 is small, the parallelism 6 occasionally becomes large and the danger of generation of a slip dislocation in the wafer becomes large. However, in the case in which a wafer is supported on a plurality of support surfaces in the present invention, not only the flatness but also the parallelism is small, and therefore, the wafer can be certainly in plane contact. In this case, it is the most preferable that the flatness and the parallelism are respectively 0 mm. However, the current measurement precision is limited to 0.001 mm.

Next, as described above, in the vertical boat 8 for heat treatment, three columns 3 are placed and fixed between a disciform top plate 1 and a disciform bottom plate 2 that is provided in parallel to face to the top plate 1, and in each of the columns 3, grooves 5 are formed with intervals in the vertical direction, and thereby the support surfaces 4 for holding the wafer can be formed so as to extend in the inward side.

Therefore, the present invention is applicable for the ladder boat in which the structure of the column is simple and its production cost is small and also there is less fear that the wafer quality is harmfully affected due to the stagnancy of the gas flow to the wafers or the prevention of heat radiation thereto. Accordingly, in a ladder boat, by setting a flatness of a plane formed by the plurality of the support surfaces being in contact with a same one of the objects W to be treated to be 0.03 mm or less and a parallelism thereof to be 0.07 mm or less, the wafer-like objects W to be treated and each of the support surfaces become certainly in plane contact. Furthermore, the productivity is extremely high and a slip dislocation can be very effectively prevented from being generated.

In the above case, the number of the columns is not limited to three as described above, and may be two, three of more, and can be one in the case in which the column has a cylinder shape. By forming grooves on an inner surface of the column that has a cylinder shape and by providing through-holes, the column can have a plurality of support surfaces.

Furthermore, the boat is constituted so that a sum total of contact areas of the wafer-like object W to be treated and the plurality of support surfaces formed on the columns is 2% or less of an area of the wafer-like object W to be treated. Thereby, the stagnancy of the flow of the atmospheric gas is not caused on the peripheral portion of the object W to be treated, and therefore, heat-treated wafers of high quality, for example, having a high uniform thickness of the oxide film can be more certainly obtained. In this case, if the sum total of contact areas of the wafer-like object W to be treated and the plurality of support surfaces formed on the columns is less than 1% of the area of the wafer-like object W to be treated, the stress due to the load in the support points increases. Therefore, it is preferable that the sum total of contact areas of the wafer-like object W to be treated and the plurality of support surfaces formed on the columns is 1% or more of the area of the wafer-like object W to be treated.

Moreover, materials of the top plate 1, the bottom plate 2, and the columns 3 are not particularly limited. However, the materials having excellent heat resistance are preferable so as to be capable of resisting a heat treatment at a high temperature of 1200°C or more. In particular, the columns 3 are in contact with or approximated to all of the wafer-like objects W to be treated, and therefore, it is preferable that the columns made of any one material of quartz glass, silicon carbide, silicon, and complex of silicon carbide and silicon, which is a material having excellent heat resistance and not contaminating the wafer-like object W to be treated are used, and the silicon carbide is particularly preferable.

Moreover, in order to high-precisely process the flatness and the parallelism of the plurality of support surfaces 4a, 4b formed on the columns 3, the column 3 is firmly fixed not to move in the grooving process of the column 3.

Such a vertical boat 8 for heat treatment according to the present invention can be particularly suitably used in the case of heat-treating the semiconductor wafer having a diameter of 200 mm or more, particularly, a silicon wafer having a large diameter of 300 mm or more. If a silicon wafer having own heavy weight and a large diameter of 300 mm or more is heat-treated at 1000°C or more, generation of a slip dislocation becomes marked. Accordingly, even in such a case, by using the vertical boat 8 for heat treatment according to the present invention, both of the flatness and the parallelism of the support surfaces can be controlled and thereby a slip dislocation can be very effectively prevented from being generated.

In addition, although the heat treatment temperature depends on the purpose, a slip dislocation is easily generated at 1000°C or more, and at 1300°C or more, contamination becomes easily caused as well as a slip dislocation.

Therefore, in the case in which silicon wafers are heat-treated in such a vertical heat treatment furnace 9 as shown in Fig. 1 at a temperature of 1000°C or more and the melting point of the semiconductor wafer or less, particularly in the case in which silicon wafers having a large diameter of 300 mm or more are heat-treated at 1100°C or more and 1300°C or less, the wafers are supported by using the vertical boat for heat treatment according to the present invention, that is using a boat in which both of the flatness and the parallelism of the support surfaces are controlled, and thereby, a slip dislocation can be very effectively prevented from being generated, and also generation of contamination can be prevented. As a whole, a larger number of wafers can be heat-treated. Therefore, both of yield and productivity can be improved.

Hereinafter, Examples of the present invention will be explained.

### (Example 1)

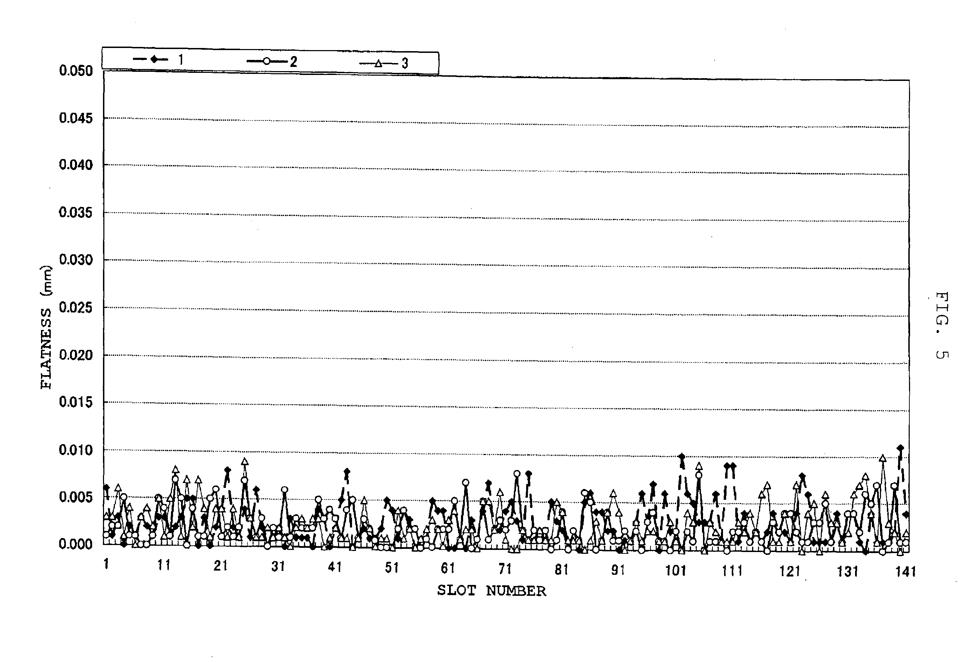

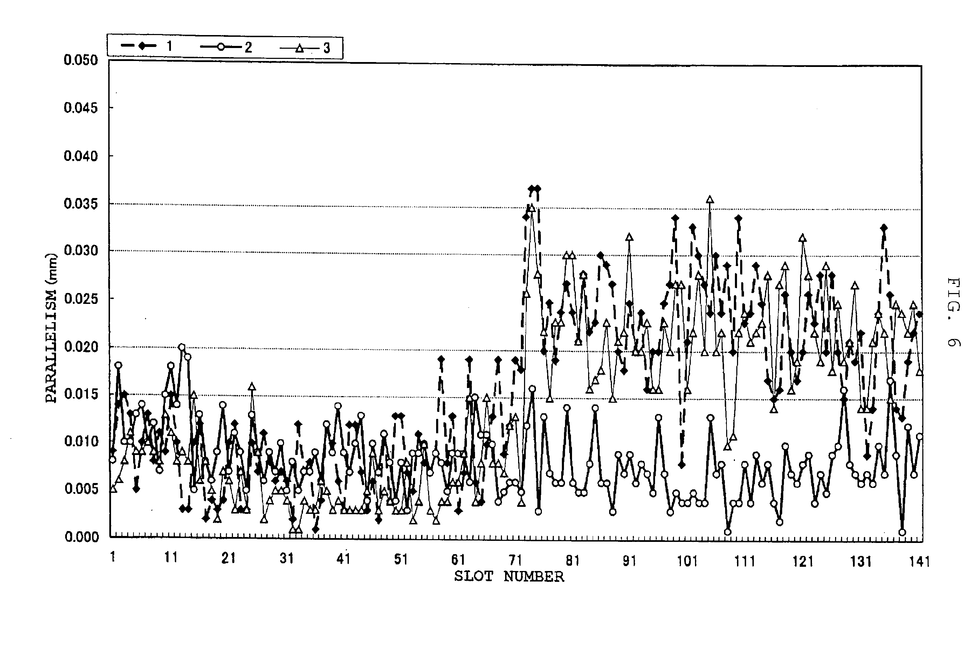

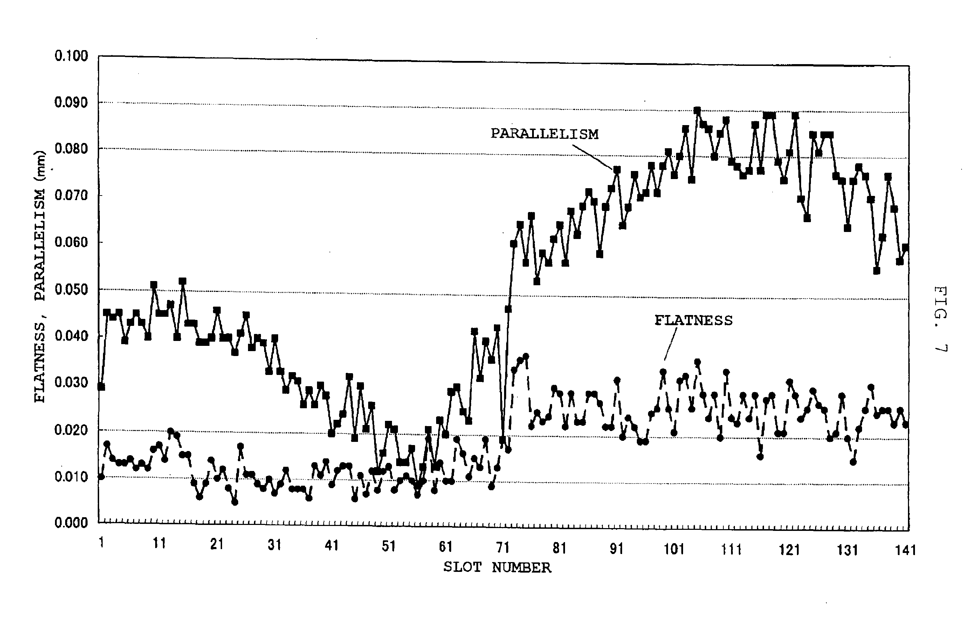

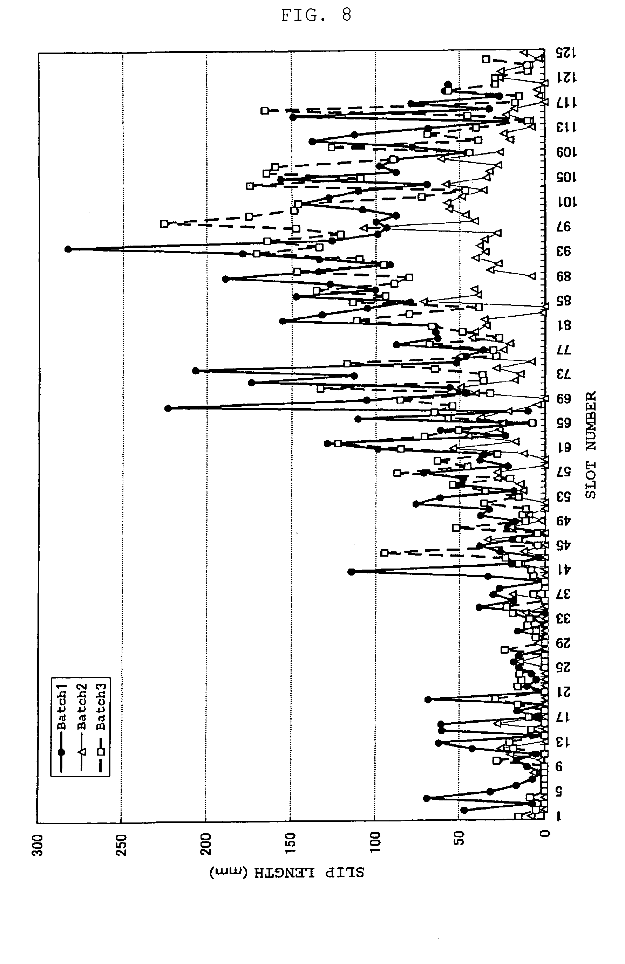

Silicon wafers having a diameter of 300 mm were stocked in a ladder-shaped vertical boat for heat treatment that has three columns and 141 grooves as shown in Fig. 2, and annealed 1200°C / 1 hr under an Ar atmosphere, and then slip dislocation on the silicon wafer was measured. Three batches of heat treatments were performed repeatedly by using the same vertical boat 8 for heat treatment. The individual flatnesses of the respective support surfaces in this vertical boat 8 for heat treatment are shown in Fig. 5, and the individual parallelisms of the respective support surfaces are shown in Fig. 6, and the flatnesses and the parallelisms of the respective slots (a plane formed by the three support surfaces) are shown in Fig. 7. In this case, in the measurement of the parallelism, the bottom surface of the bottom plate of the vertical boat 8 for heat treatment was set to the reference plane. And, the lengths of the slip dislocations that were generated in the wafers after the heat treatment are shown in Fig. 8. The lengths of the slip dislocations were evaluated by summing each of the lengths of slip dislocation(s) generated on the wafer surface by a particle counter (SP1 manufactured by KLA-Tencor Inc.). In addition, the sum total of the areas of support surfaces being in contact with the wafer was set to 1.4% of the area of the wafer.

As a result, as shown in Figs. 5 and 6, the individual flatnesses of the respective support surfaces were 0.01 mm or less and the individual parallelisms of the respective support surfaces were 0.04 mm or less. However, in the respective slots, as shown in Figs. 7 and 8, the result was that with respect to the flatnesses and/or the parallelisms in the slot number 71 or larger, the flatnesses were more than 0.03 mm and the parallelism was more than 0.07 mm. In this slot number 71 or larger, a large number of wafers of extremely long slip dislocations having lengths of 100 mm or more were observed. In this case, the measurement limitations of the flatness and the parallelism were limited to 0.001 mm.

On the other hand, any one of the flatnesses in the slot number of 70 or smaller was not more than 0.03 mm and any one of the parallelisms therein was not more than 0.07 mm. In this slot number 70 or smaller, the extremely long slip dislocation having a length of 100 mm or more was hardly observed except for the sample of the slot number 68 in the batch 1.

From these results, it is found that when the flatness of each of the slots is 0.03 mm or less and the parallelism thereof is 0.07 mm or less, a slip dislocation can be very effectively prevented from being generated.

### (Example 2)

The sum total of the areas of the support surfaces being in contact with the wafer was set to 1.4% of the area of the same wafer, and silicon wafers having a diameter of 300 mm were stocked in a ladder-shaped vertical boat for heat treatment that has 141 grooves as shown in Fig. 2, and annealed in an oxygen atmosphere and thereby, an oxide film of a film thickness of 250 Å was formed. In this case, five points of the oxide film thickness were measured by an ellipsometer. This was repeated by using the same vertical boat for heat treatment and 4 batches of the heat treatments were performed. As a result, the average value of the oxide film thickness was 244.3 Å, and the standard deviation thereof was 2.7. Moreover, as a result of evaluating uniformity of the oxide film thickness by the standard deviation / the average value of the oxide film thickness, the average of its value was 1.0% (the maximum was 1.5% and the minimum was 0.4%).

On the other hand, the sum total of the areas of the support surfaces being in contact with the wafer was set to 2.1% of the area of the same wafer, and the same treatment was performed. Therefore, the average value of the oxide film thickness was 256.7 Å, and the standard deviation thereof was 6.3. Moreover, as a result of evaluating uniformity of the oxide film thickness by the standard deviation / the average value of the oxide film thickness, the average of its value was 1.5% (the maximum was 2.5% and the minimum was 1.0%) .

From these results, it is found that when the sum total of the areas of the support surfaces being in contact with the wafer becomes increased, the uniformity of the oxide film thickness is harmfully affected. However, because the effect of such an extent of the difference on the wafer quality is small, it is more preferable that the sum total of the areas of support surfaces being in contact with the wafer is 2% or less of the area of the same wafer.

### (Comparative example 1)

By using a ring boat in which the flatness of a support surface of each of shelves for placement formed in an arc shape on the inner wall face of a cylinder-shaped boat main body (column) was set to be 0.1 mm or less, wafers having a diameter of 300 mm were subjected to heat treatment at a temperature of 1200°C. As a result, lengths of slip dislocations were 100 mm or more and with respect to the uniformity of the oxide film, the average value evaluated by the standard deviation / the average value of the oxide film thickness was 5% or more, and therefore uniformity was bad. As described above, in the case in which only the flatness was prescribed but the parallelism was not controlled, a slip dislocation having a long length is occasionally generated when a high-temperature heat treatment is performed. Moreover, in the structure for holding a large part of the peripheral portion of the wafer in an arc shape, because the volume of the entirety of the support body is increased, stagnancy in the flow of the gas to the wafers is caused and heat treatment radiation to the wafer is prevented. And thereby, there is such harmful effect on the wafer quality that the uniformity of the oxide film thickness becomes degraded.

The present invention is not limited to the above-described embodiments. The above-described embodiments are mere examples, and those having the substantially same constitution as that described in the appended claims and providing the similar action and advantages are included in the scope of the present invention.

In the above-described embodiments, an example of a ladder-shaped vertical boat for heat treatment has been explained. However, the present invention is not limited to these embodiments. In the present invention, when the parallelism and the flatness of a plurality of the support surfaces are set in the prescribed ranges of the present invention, independently from the shape of the vertical boat for heat treatment, the same effects can be obtained.

## Claims

1. A vertical boat for heat treatment by which a plurality of wafer-like objects to be treated are supported with an interval in a vertical direction by a column having support surfaces and carried into a vertical heat treatment apparatus and carried out, wherein a lower surface of each of the wafer-like objects to be treated is supported by a plurality of support surfaces formed on the column, a flatness of a plane formed by the plurality of the support surfaces being in contact with a same one of the objects to be treated is 0.03 mm or less, and a parallelism thereof is 0.07 mm or less.

2. The vertical boat for heat treatment according to Claim 1, wherein in the column, a plurality of arm portions each extending toward an inward side are formed with an interval in the vertical direction, and on an upper surface of an inner end side of each of the arm portions, an inward side of a peripheral border portion of each of the wafer-like objects to be treated is supported.

3. The vertical boat for heat treatment according to Claim 1 or 2, wherein the vertical boat for heat treatment has, at least, two columns.

4. The vertical boat for heat treatment according to any one of Claims 1 to 3, wherein the column is provided between a top plate and a bottom plate.

5. The vertical boat for heat treatment according to any one of Claims 1 to 4, wherein a sum total of contact areas of the wafer-like object to be treated and the plurality of support surfaces formed on the column is 2% or less of an area of the wafer-like object to be treated.

6. The vertical boat for heat treatment according to any one of Claims 1 to 5, wherein, at least, the column of the vertical boat for heat treatment is made of any one of quartz glass, silicon carbide, silicon, and complex of silicon carbide and silicon.

7. A method for heat-treating a semiconductor wafer, wherein by using the vertical boat for heat treatment according to any one of Claims 1 to 6, the semiconductor wafer supported by the boat is heat-treated at a temperature of 1000°C or more, and a melting point of the semiconductor wafer or less.

8. The method for heat-treating a semiconductor wafer according to Claim 7, wherein as the semiconductor wafer, a silicon wafer having a diameter of 300 mm or more is heat-treated.
